# EUROPEAN PATENT APPLICATION

(11) **EP 4 797 531 A1**
(43) Date of publication of application: **26.08.2026**
(21) Application number: 24879008.1
(22) Date of filing: 15.10.2024
(51) Int. Cl.: H03F 1/52

(54) **POWER AMPLIFIER MODULE FOR IMPLEMENTING AVERAGE POWER PROTECTION, ELECTRONIC DEVICE, AND METHOD**

(30) Priority: 20.10.2023 CN 202311365604
(71) Applicant: Vanchip (Tianjin) Technology Co. Ltd, Tianjin 300457 (CN)
(72) Inventor: GAO, Chenyang, Tianjin 300457 (CN); LI, Hao, Tianjin 300457 (CN); ZHANG, Silong, Tianjin 300457 (CN)
(74) Representative: Wang, Bo
(86) International application number: PCT/CN2024/125086
(87) International publication number: WO 2025/082366

(57) **Abstract**

Disclosed in the present invention are a power amplifier module for implementing average power protection, an electronic device, and a method. The power amplifier module comprises: a controller, configured to provide logic control and bias voltage for a radio frequency power amplifier; the radio frequency power amplifier, configured to amplify the power of a radio frequency signal and then output the amplified radio frequency signal to a filter; and a filter for frequency bands, configured to filter the amplified radio frequency signal to obtain a radio frequency signal of a required specific frequency band. When the detected power of the radio frequency power amplifier is greater than or equal to a first power threshold, and the time during which the detected power is greater than or equal to the first power threshold reaches a first time threshold, the power amplifier module enters an average power protection operating mode, and the controller adjusts the gain of a power amplification unit, so as to protect the filter in the power amplifier module from being burnt out.

## Description

### BACKGROUND

### Technical Field

The present invention relates to a power amplifier module for implementing average power protection, an electronic device including the power amplifier module, and a method for average power protection of a power amplifier module, and belongs to the field of radio frequency integrated circuit technologies.

### Related Art

In a related technology, mainstream radio frequency front end integration solutions include PAMiD and L-PAMiD. The PAMiD modularizes a power amplifier, a radio frequency switch, and a filter together. The L-PAMiD modularizes a power amplifier, a radio frequency switch, a filter, and a low-noise amplifier together. A new problem is brought while a smaller size of a radio frequency front end module is implemented by using the PAMiD and the L-PAMiD. Because a filter needs to be integrated and miniaturized in a module, stability and reliability of the filter are degraded. Consequently, the filter is easily burnt out when a power amplifier abnormally outputs a high power. This not only increases stability and reliability risks existing in the PAMiD and the L-PAMiD, but also even affects evolution of high integration and miniaturization of the radio frequency front end module. Therefore, how to protect the filter in the module from being burnt out when the power amplifier abnormally outputs a high power becomes a problem that shall be resolved for the radio frequency front end module. In other words, how to limit or reduce a power output when the power amplifier abnormally outputs a high power is an urgent problem to be resolved.

### SUMMARY

A primary technical problem to be resolved in the present invention is to provide a power amplifier module for implementing average power protection.

Another technical problem to be resolved in the present invention is to provide an electronic device including the power amplifier module.

Another technical problem to be resolved in the present invention is to provide a method for average power protection of a power amplifier module.

To achieve the foregoing objectives, the present invention adopts the following technical solutions.

According to a first aspect of embodiments of the present invention, a power amplifier module for implementing average power protection is provided, including: a controller, configured to provide logic control and a bias voltage for a radio frequency power amplifier; the radio frequency power amplifier, configured to amplify a power of a radio frequency signal and then output an amplified radio frequency signal to a filter; and the filter for frequency bands, configured to filter the amplified radio frequency signal, to obtain a radio frequency signal of a required specific frequency band, where
when a detected power of the radio frequency power amplifier is greater than or equal to a first power threshold, and a time during which the detected power is greater than or equal to the first power threshold reaches a first time threshold, the power amplifier module enters an average power protection operating mode, and the controller adjusts a gain of a power amplifier unit.

Preferably, when a time during which the power amplifier module enters the average power protection operating mode reaches a second time threshold, the power amplifier module exits the average power protection operating mode; then whether the detected power of the radio frequency power amplifier is less than or equal to a second power threshold is determined; and when the detected power is less than or equal to the second power threshold, the power amplifier module continues to exit the average power protection operating mode; otherwise, the power amplifier module continues to enter the average power protection operating mode.

Preferably, the controller includes:
a power comparison unit, configured to perform comparison and determine whether the detected power reaches a set power threshold, and output a first control signal;
a bandgap reference, configured to provide a reference voltage for each relevant unit;
a frequency oscillator, configured to generate a clock signal and provide the clock signal to a timing unit;
the timing unit, configured to perform timing by using the clock signal, and output a second control signal after comparison with a set time threshold;
a VBIAS LDO circuit, configured to output a first bias voltage to a biasing unit of the radio frequency power amplifier;
a radio frequency input switch unit, configured to switch two radio frequency paths with different attenuation amounts; and
a logic control unit, configured to perform logic combination based on the first control signal and the second control signal, output a third control signal, and control a relevant functional unit to adjust the gain of the power amplifier unit, to achieve protection.

Preferably, the controller further includes:
a VLPM LDO circuit, configured to output a second bias voltage, as a node potential, to the biasing unit of the radio frequency power amplifier, to change a bias voltage outputted by the biasing unit; and
an Efuse calibration unit, outputting a digital signal for performing calibration on the reference voltage of the bandgap reference, to ensure accuracy of the reference voltage.

Preferably, the power comparison unit includes a first voltage comparator and a second voltage comparator, where an input end of the first voltage comparator is separately connected to a first reference voltage end and an output end of a power detection unit, and an input end of the second voltage comparator is separately connected to a fifth reference voltage end and the output end of the power detection unit; and an output end of the first voltage comparator and an output end of the second voltage comparator each are connected to an output end of the power comparison unit, where
the first voltage comparator is configured to compare a first voltage outputted by the power detection unit with a first reference voltage; the second voltage comparator is configured to compare the first voltage outputted by the power detection unit with a fifth reference voltage in different time periods; and the first control signal is outputted based on a comparison result.

Preferably, the power comparison unit includes an analog-to-digital converter and a digital logic unit, where an input end of the analog-to-digital converter is connected to an output end of a power detection unit, an output end of the analog-to-digital converter is connected to a first input end of the digital logic unit, a second input end and a third input end of the digital logic unit each are connected to an Efuse calibration unit, and an output end of the digital logic unit is used as an output end of a power amplification unit, where
the analog-to-digital converter is configured to convert a first voltage outputted by the power detection unit into a fourth digital signal; the digital logic unit is configured to compare, in different time periods, the fourth digital signal separately with a second digital signal and a third digital signal that are provided by the Efuse calibration unit; and the first control signal is outputted based on a comparison result.

Preferably, the radio frequency power amplifier includes:
a biasing unit, configured to provide a direct current operating point for a power amplification unit;
a power detection unit, configured to perform power detection on a radio frequency signal outputted by the power amplification unit, wherein a first voltage is outputted corresponding to a detection result; and
the power amplification unit, configured to amplify an inputted radio frequency signal and then output an amplified radio frequency signal.

Preferably, the third control signal outputted by the logic control unit controls the radio frequency input switch unit, where
when the power amplifier module enters the average power protection operating mode, a radio frequency input signal is outputted after passing through a radio frequency path with an attenuation network, causing reduction of a gain of a power amplification unit; and
when the power amplifier module exits the average power protection operating mode, the radio frequency input signal is outputted after passing through a radio frequency path without an attenuation network, and in this case, the power amplification unit maintains a normal gain.

Preferably, in the radio frequency input switch unit, the radio frequency path with an attenuation network and the radio frequency path without an attenuation network are connected in parallel with each other; the radio frequency path with an attenuation network includes a first switch, the attenuation network, and a second switch, and the first switch, the attenuation network, and the second switch are sequentially connected in series, where a control end of the first switch and a control end of the second switch each are connected to a third control signal end; and the radio frequency path without an attenuation network includes a third switch, and a control end of the third switch is connected to an inverted signal end of the third control signal.

Preferably, the third control signal outputted by the logic control unit controls the VBIAS LDO circuit, where
when the power amplifier module enters the average power protection operating mode, the VBIAS LDO circuit outputs a reduced first bias voltage to the biasing unit of the power amplifier, and a gain of a power amplification unit is reduced; and
when the power amplifier module exits the average power protection operating mode, the VBIAS LDO circuit outputs a normal first bias voltage to the biasing unit of the power amplifier, and in this case, the power amplification unit maintains a normal gain.

Preferably, the VBIAS LDO circuit includes an error amplifier, a power transistor, a feedback resistor network, and a first resistor, a second resistor, and a PMOS transistor that are connected in series at an output end, where a source and a drain of the PMOS transistor are respectively connected to two ends of the second resistor, and a gate of the PMOS transistor is connected to a third control signal end.

Preferably, the VBIAS LDO circuit includes an error amplifier, a power transistor, and a feedback resistor network, where the feedback resistor network includes a third resistor, a fourth resistor, and a fifth resistor that are connected in series between an output end and a ground potential end, a first transmission gate, and a second transmission gate; a connection point between the third resistor and the fourth resistor is a first node, and a connection point between the fourth resistor and the fifth resistor is a second node; and the first node and the second node are respectively connected to a feedback input end of the error amplifier correspondingly through the first transmission gate and the second transmission gate, an enable control end of the first transmission gate is connected to a third control signal end, and an enable control end of the second transmission gate is connected to an inverted signal end of the third control signal.

Preferably, the third control signal outputted by the logic control unit controls the VLPM LDO circuit, where
when the power amplifier module enters the average power protection operating mode, the VLPM LDO circuit outputs a high-potential second bias voltage to a biasing unit of a power amplifier, to change a node potential in the biasing unit, causing the biasing unit to output a reduced bias voltage, and a gain of a power amplification unit is reduced.

When the power amplifier module exits the average power protection operating mode, the VLPM LDO circuit outputs a low-potential second bias voltage to the biasing unit of the power amplifier, causing the biasing unit to output a normal bias voltage, and the power amplifier maintains a normal gain.

According to a second aspect of the embodiments of the present invention, an electronic device is provided, including the foregoing power amplifier module for implementing average power protection.

According to a third aspect of the embodiments of the present invention, a method for average power protection of a power amplifier module is provided, including the following steps:
(1) detecting a power in a power amplifier module;
(2) determining whether a detected power is greater than or equal to a first power threshold; and performing a next step when the detected power is greater than or equal to the first power threshold; otherwise, returning to step (1) and continuing to detect the power;
(3) starting timing after the detected power is greater than or equal to the first power threshold, wherein the timing is a first timing time;
(4) determining whether the first timing time reaches a first time threshold; and performing a next step when the first timing time reaches the first time threshold; otherwise, returning to step (1);
(5) entering, by the power amplifier module, an average power protection operating mode; and adjusting, by a control circuit, a gain of a power amplifier unit, to protect the power amplifier module;
(6) starting timing after the power amplifier module enters the average power protection operating mode, wherein the timing is a second timing time;
(7) determining whether the second timing time reaches a second time threshold; and performing a next step when the second timing time reaches the second time threshold; otherwise, returning to step (6) and continuing the timing;
(8) exiting, by the power amplifier module, the average power protection operating mode;
(9) determining whether the detected power is less than or equal to a second power threshold; and performing a next step when the detected power is less than or equal to the second power threshold; otherwise, returning to step (5) and continuing to enter, by the power amplifier module, the average power protection operating mode; and
(10) continuing to exit, by the power amplifier module, the average power protection operating mode; and returning to step (1).

Preferably, in step (5), the control circuit controls a radio frequency input switch unit; and when the power amplifier module enters the average power protection operating mode, a radio frequency input signal is outputted after passing through a radio frequency path with an attenuation network, causing reduction of a gain of a power amplification unit.

Preferably, in step (5), the control circuit controls a VBIAS LDO circuit; and when the power amplifier module enters the average power protection operating mode, the VBIAS LDO circuit outputs a reduced first bias voltage to a biasing unit of a power amplifier, and a gain of a power amplification unit is reduced.

Preferably, in step (5), the control circuit controls a VLPM LDO circuit; and when the power amplifier module enters the average power protection operating mode, the VLPM LDO circuit outputs a high-potential second bias voltage to a biasing unit of a power amplifier, to change a node potential in the biasing unit, causing the biasing unit to output a reduced bias voltage, and a gain of a power amplification unit is reduced.

Compared with the related art, according to the power amplifier module for implementing average power protection provided in the present invention, a control signal is generated after real-time power detection and comparison with a set threshold, and a relevant functional unit is controlled to adjust a gain of a power amplifier unit. This technical solution implements protection of the power amplifier module when an abnormally high power occurs. In this way, a radio frequency front end module can continue to evolve towards higher integration and miniaturization. Therefore, the power amplifier module for implementing average power protection according to the present invention has beneficial effects such as ingenious and proper structural design, low design costs, and high reliability.

### BRIEF DESCRIPTION OF THE DRAWINGS

FIG. 1 is a structural block diagram of a power amplifier module for implementing average power protection according to the present invention;
FIG. 2 is a circuit principle diagram of a power comparison unit in a first solution according to an embodiment of the present invention;
FIG. 3 is a circuit principle diagram of a power comparison unit in a second solution according to an embodiment of the present invention;
FIG. 4 is a circuit principle diagram of implementing average power protection according to a first embodiment of the present invention;
FIG. 5 is a circuit principle diagram of implementing average power protection according to a second embodiment of the present invention;
FIG. 6 is a circuit principle diagram of implementing average power protection according to a third embodiment of the present invention;
FIG. 7 is a schematic diagram of an electronic device using a power amplifier module for implementing average power protection according to the present invention; and
FIG. 8 is a flowchart of a method for average power protection of a power amplifier module according to an embodiment of the present invention.

### DETAILED DESCRIPTION

The technical content of the present invention is described in detail below with reference to the accompanying drawings and specific embodiments.

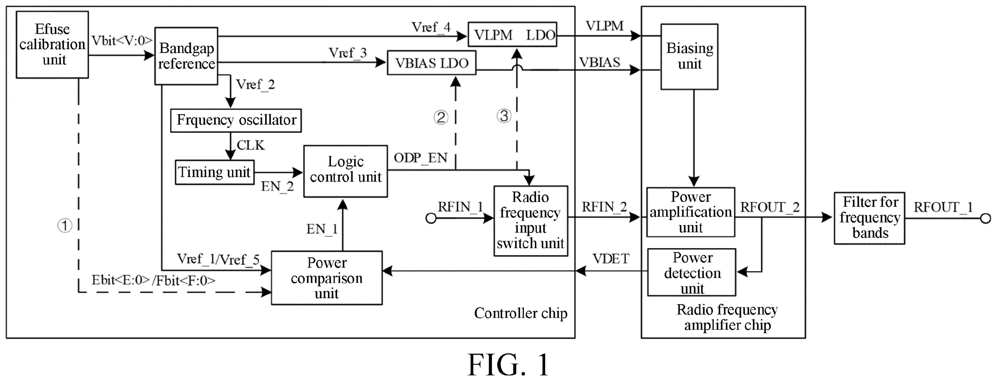

As shown in FIG. 1, a power amplifier module for implementing average power protection according to an embodiment of the present invention includes: a controller, configured to provide logic control and a bias voltage for a radio frequency power amplifier; the radio frequency power amplifier, configured to amplify a power of a radio frequency signal and then output an amplified radio frequency signal to a filter; and the filter for frequency bands, configured to filter the amplified radio frequency signal, to obtain a radio frequency signal of a required specific frequency band.

The controller includes a power comparison unit, a bandgap reference, a frequency oscillator, a timing unit, a VBIAS LDO circuit, a VLPM LDO circuit, a radio frequency input switch unit, an Efuse calibration unit, and a logic control unit. The foregoing units of the controller are integrated together to form a controller chip.

Functions and effects of the functional units are respectively described below.

The power comparison unit is configured to perform comparison and determine whether a detected power reaches a set power threshold. The power comparison unit compares a first voltage VDET that is fed back by a power detection unit and that represents a power level with the set power threshold, and a first control signal EN_1 is outputted based on a comparison result. The set power threshold includes a first power threshold Vth1 and a second power threshold Vth2. The first power threshold Vth1 is set based on a power level that the filter integrated in the power amplifier module can withstand. High and low levels of the first control signal EN_1 correspondingly represent whether the first voltage VDET reaches the set first power threshold Vth1 or the set second power threshold Vth2.

The bandgap reference is mainly configured to provide a reference voltage Vref for each relevant unit. A first reference voltage Vref_1 and a fifth reference voltage Vref_5 are provided for the power comparison unit, a second reference voltage Vref_2 is provided for the frequency oscillator, a third reference voltage Vref_3 is provided for the VBIAS LDO circuit, and a fourth reference voltage Vref_4 is provided for the VLPM LDO circuit.

The frequency oscillator is configured to generate a clock signal CLK and provide the clock signal CLK to the timing unit. In an embodiment of the present invention, the frequency oscillator is implemented by using a voltage comparison circuit structure. An advantage is that accuracy of the second reference voltage Vref_2 outputted by the bandgap reference can be ensured by using the Efuse calibration unit, thereby ensuring accuracy of the clock signal CLK generated by the frequency oscillator. A circuit structure of the frequency oscillator is not limited in the embodiments of the present invention, and may alternatively be implemented by using another circuit structure provided that the clock signal generated by the frequency oscillator satisfies a requirement.

The timing unit performs timing by using the clock signal CLK provided by the frequency oscillator, and performs comparison with a set time threshold. A second control signal EN_2 is outputted based on a comparison result. The set time threshold includes a first time threshold Tth1 and a second time threshold Tth2. The first time threshold Tth1 is determined and set jointly based on a duration for which the filter can withstand a high power and a duration needed to be covered for the filter in normal application. The timing of the timing unit includes a time t1 of reaching the set first power threshold Vth1 and a time t2 of entering an average power protection operating mode. High and low levels of the second control signal EN_2 correspondingly represent whether a timing time reaches the set first time threshold Tth1 or the set second time threshold Tth2. The timing unit may be implemented through a D flip-flop and a logic gate circuit.

The VBIAS LDO circuit is configured to output a first bias voltage VBIAS, as a bias power supply, in a normal operating mode to a biasing unit of the radio frequency power amplifier, to establish a direct current operating point of the biasing unit.

The VLPM LDO circuit is configured to output a second bias voltage VLPM, as a node potential, in a low-power mode to the biasing unit in a radio frequency power amplifier chip, to change a bias voltage outputted by the biasing unit.

The radio frequency input switch unit is configured to switch two radio frequency paths with different attenuation amounts. One of the radio frequency paths is provided with an attenuation network, while the other of the radio frequency paths is not provided with an attenuation network. Different amplification gains of a radio frequency signal may be achieved through selection of the different radio frequency paths.

The logic control unit is configured to perform logic combination based on the first control signal EN_1 outputted by the power comparison unit and the second control signal EN_2 outputted by the timing unit, and output a third control signal ODP_EN, for controlling a relevant functional unit to adjust a gain of a power amplifier, to achieve average power protection. High and low levels of the third control signal ODP_EN correspondingly represent whether the power amplifier module enters the average power protection operating mode.

The Efuse calibration unit is configured to perform calibration on the reference voltage of the bandgap reference. Accuracy of the first reference voltage Vref_1, the second reference voltage Vref_2, the third reference voltage Vref_3, the fourth reference voltage Vref_4, and the fifth reference voltage Vref_5 that are outputted by the bandgap reference is ensured through an outputted first digital signal Vbit<V:0>. Further, accuracy of the first reference voltage Vref_1 and the fifth reference voltage Vref_5 are ensured, to ensure accuracy of the set first power threshold Vth1 and the set second power threshold Vth2. Accuracy of the second reference voltage Vref_2 is ensured, to ensure accuracy of the clock signal CLK outputted by the frequency oscillator, that is, to ensure accuracy of the set first time threshold Tth1 and the set second time threshold Tth2. Therefore, a deviation caused by a manufacturing process can be significantly reduced by using the Efuse calibration unit, to ensure accuracy of average power protection for each chip. In addition, in some embodiments of the present invention, the Efuse calibration unit provides digital values of the set first power threshold Vth1 and the set second power threshold Vth2 for the power comparison unit by outputting a second digital signal Ebit<E:0> and a third digital signal Fbit<F:0>.

The radio frequency power amplifier includes the biasing unit, a power amplification unit, and the power detection unit. The foregoing units of the radio frequency power amplifier are integrated together to form the radio frequency power amplifier chip. Functions and effects of the units are respectively described below.

The biasing unit is configured to provide a direct current operating point for the power amplification unit. Operating power supplies of the biasing unit are provided by the controller, and are respectively the first bias voltage VBIAS in the normal operating mode and the second bias voltage VLPM in the low-power mode.

The power detection unit is configured to perform detection on a radio frequency signal RFOUT_2 outputted by the power amplification unit. A first voltage VDET is outputted corresponding to a detection result. A power level of the radio frequency signal RFOUT_2 is in a positive correlation with a level of the first voltage VDET. In other words, the greater power of the RFOUT_2 indicates the greater first voltage VDET.

The power amplification unit is configured to amplify an inputted radio frequency signal RFIN_2 and then output the radio frequency signal RFOUT_2. The radio frequency signal RFOUT_2 outputted by the power amplification unit passes through the filter, and then a radio frequency signal RFOUT_1 of a required specific frequency band is outputted.

It should be noted that, the power comparison unit in this embodiment of the present invention may use any one of the following two technical solutions.

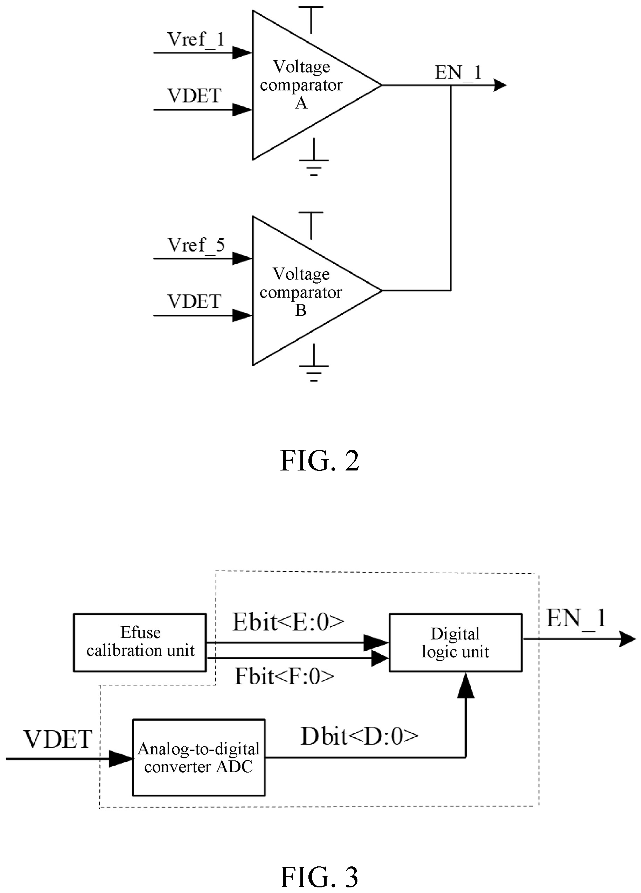

In a first solution, as shown in FIG. 2, the power comparison unit is implemented by using an analog circuit. A first voltage comparator A is used to compare the first voltage VDET outputted by the power detection unit with the first reference voltage Vref_1, and the first control signal EN_1 is outputted based on a comparison result. The high and low levels of the first control signal EN_1 correspond to whether a detected power reaches the set first power threshold Vth1. A second voltage comparator B is used to compare the first voltage VDET outputted by the power detection unit with the fifth reference voltage Vref_5, and the first control signal EN_1 is outputted based on a comparison result. The high and low levels of the first control signal EN_1 correspond to whether a detected power reaches the set second power threshold Vth2.

An input end of the first voltage comparator A is separately connected to a first reference voltage Vref_1 end and a first voltage VDET end, and an input end of the second voltage comparator B is separately connected to a fifth reference voltage Vref_5 end and the first voltage VDET end. An output end of the first voltage comparator A and an output end of the second voltage comparator B each are connected to an output end of the power comparison unit. In addition, the first voltage comparator A and the second voltage comparator B each are controlled by a system enable signal for operation, and respectively operate in different time periods.

When the detected power is greater than or equal to the first power threshold Vth1, that is, when the first voltage VDET is greater than or equal to the first reference voltage Vref_1, the first voltage comparator A operates, and the first control signal EN_1 outputted by the power comparison unit is a high-level signal.

When the detected power is less than or equal to the second power threshold Vth2, that is, when the first voltage VDET is less than or equal to the fifth reference voltage Vref_5, the second voltage comparator B operates, and the first control signal EN_1 outputted by the power comparison unit is a low-level signal.

Levels of the first reference voltage Vref_1 and the fifth reference voltage Vref_5 are determined through design respectively based on the set first power threshold Vth1 and the set second power threshold Vth2. In other words, a power level is represented by using a voltage.

In a second solution, as shown in FIG. 3, the power comparison unit is implemented by using a digital circuit. Specifically, the power comparison unit is formed by an analog-to-digital converter ADC and a digital logic unit. An input end of the analog-to-digital converter ADC is connected to an output end of the power detection unit, an output end of the analog-to-digital converter ADC is connected to a first input end of the digital logic unit, a second input end and a third input end of the digital logic unit each are connected to the Efuse calibration unit (as shown in a dashed line ① in FIG. 1), and an output end of the digital logic unit is used as an output end of the power amplification unit.

The analog-to-digital converter ADC converts the first voltage VDET outputted by the power detection unit into a fourth digital signal Dbit<D:0>, then the fourth digital signal Dbit<D:0> is compared, through the digital logic unit in different time periods, with the second digital signal Ebit<E:0> and the third digital signal Fbit<F:0> that are provided by the Efuse calibration unit, and the first control signal EN_1 is outputted based on a comparison result. High and low levels of the first control signal EN_1 outputted after comparison of the fourth digital signal Dbit<D:0> with the second digital signal Ebit<E:0> correspond to whether the detected power reaches the set first power threshold Vth1. High and low levels of the first control signal EN_1 outputted after comparison of the fourth digital signal Dbit<D:0> with the third digital signal Fbit<F:0> correspond to whether the detected power reaches the set second power threshold Vth2.

Numbers of the second digital signal Ebit<E:0> and the third digital signal Fbit<F:0> are determined through design respectively based on the set first power threshold Vth1 and the set second power threshold Vth2. In other words, a power level is represented by using a number.

When the detected power is greater than or equal to the first power threshold Vth1, that is, when the fourth digital signal Dbit<D:0> is greater than or equal to the second digital signal Ebit<E:0>, the first control signal EN_1 outputted by the power comparison unit is a high-level signal.

When the detected power is less than or equal to the second power threshold Vth2, that is, when the fourth digital signal Dbit<D:0> is less than or equal to the third digital signal Fbit<F:0>, the first control signal EN_1 outputted by the power comparison unit is a low-level signal.

In comparison of the two technical solutions for implementing the power amplification unit, a circuit structure is simple but accuracy is not high in the first solution; while a circuit structure is complex but accuracy is high in the second solution. In actual application, appropriate selection can be performed according to an actual requirement.

An operating principle of the power amplifier module for implementing average power protection according to the present invention is described in general below with reference to different embodiments.

The power detection unit of the radio frequency power amplifier detects a level of an output power in real time. The power detection unit outputs the first voltage VDET representing the power level. When the first voltage VDET is greater than or equal to the set first power threshold Vth1, the power comparison unit outputs the high-level first control signal EN_1 to the logic control unit, and simultaneously, the timing unit starts timing. When a timing time reaches the first time threshold Tth1, the timing unit outputs the high-level second control signal EN_2 to the logic control unit. In this case, the power amplifier module enters the average power protection operating mode. In addition, the logic control unit performs logic combination based on the first control signal EN_1 and the second control signal EN_2, and outputs a high-level third control signal ODP_EN. The third control signal ODP_EN controls the relevant functional unit to adjust the gain of the power amplifier (which is mainly to reduce the gain, but is not limited thereto), to achieve protection. In addition, the timing unit starts timing after the average power protection operating mode is entered. When the timing time reaches the second time threshold Tth2, the second control signal EN_2 is changed into a low-level signal, and the power amplifier module exits the average power protection operating mode. Then, the power comparison unit continues to perform comparison and determine whether the first voltage VDET detected in real time reaches the set second power threshold Vth2. If the first voltage VDET reaches the set second power threshold Vth2, the first control signal EN_1 is changed into a low-level signal, and in this case, the power amplifier module continues to exit the average power protection operating mode; otherwise, the power amplifier module returns to (that is, continues to enter) the average power protection operating mode. This cyclical and real-time control can prevent the radio frequency power amplifier from continuously outputting an abnormally high power, to protect the module.

The set first power threshold Vth1 is generally greater than the set second power threshold Vth2 by a specific margin, to ensure that there is a specific hysteresis width between entering and exiting the average power protection operating mode.

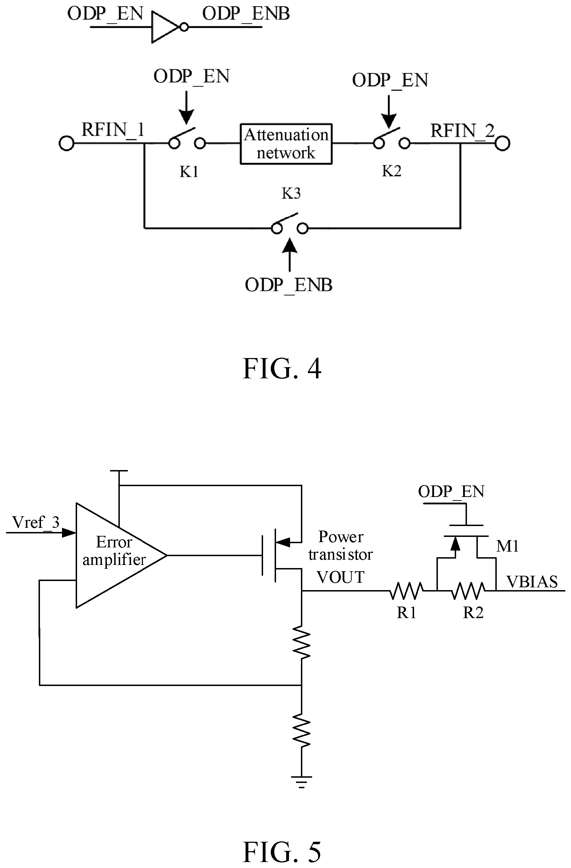

In a first embodiment of the present invention, as shown in FIG. 4, in an average power protection operating mode, a radio frequency input switch unit is controlled by a third control signal ODP_EN to adjust a gain of a power amplifier, to achieve protection.

First, an inverted signal ODP_ENB of the third control signal is obtained through an inverter circuit. In the radio frequency input switch unit, a radio frequency path with an attenuation network and a radio frequency path without an attenuation network are connected in parallel with each other. The radio frequency path with an attenuation network includes a first switch K1, the attenuation network, and a second switch K2, and the first switch K1, the attenuation network, and the second switch K2 are sequentially connected in series. A control end of the first switch K1 and a control end of the second switch K2 each are connected to a third control signal ODP_EN end. The radio frequency path without an attenuation network includes only a third switch K3, and a control end of the third switch K3 is connected to an inverted signal ODP_ENB end of the third control signal.

When a power amplifier module enters the average power protection operating mode, the third control signal ODP_EN is a high-level signal, and the inverted signal ODP_ENB of the third control signal is a low-level signal. Therefore, the first switch K1 and the second switch K2 are closed, to connect the radio frequency path with an attenuation network; and the third switch K3 is opened, to disconnect the radio frequency path without an attenuation network. In this case, after a radio frequency input signal RFIN_1 passes through the radio frequency path with an attenuation network, an attenuated radio frequency signal RFIN_2 is outputted, and a radio frequency signal RFOUT_2 outputted after the radio frequency signal RFIN_2 passes through a power amplification unit is synchronously attenuated. In other words, an output power (namely, the gain) of the power amplification unit is reduced, to achieve protection.

When the power amplifier module exits the average power protection operating mode, the third control signal ODP_EN is a low-level signal, the radio frequency input switch unit connects the path without an attenuation network and disconnects the path with an attenuation network, and the radio frequency signal RFIN_2 is outputted after the radio frequency signal RFIN_1 passes through the path without an attenuation network.

In a second embodiment of the present invention, as shown in FIG. 5, in an average power protection operating mode, a first bias voltage VBIAS outputted by a VBIAS LDO circuit is controlled by a third control signal ODP_EN (shown in a dashed line ② in FIG. 1) to adjust a gain of a power amplifier, to achieve protection.

The VBIAS LDO circuit includes an error amplifier, a power transistor, a feedback resistor network, and a first resistor R1, a second resistor R2, and a PMOS transistor M1 that are connected in series at an output end. A source and a drain of the PMOS transistor M1 are respectively connected to two ends of the second resistor R2, and a gate of the PMOS transistor M1 is connected to a third control signal ODP_EN end.

When a power amplifier module enters the average power protection operating mode, the third control signal ODP_EN is a high-level signal. Therefore, the PMOS transistor M1 is cut off. After an outputted voltage VOUT of the VBIAS LDO circuit passes through the first resistor R1 and the second resistor R2, the first bias voltage VBIAS is outputted. In this case, the first bias voltage VBIAS is reduced due to voltage division of the second resistor R2, that is, a biasing unit provides a small direct current operating point to a power amplification unit, to reduce an amplification capability (that is, to reduce a gain) of the power amplification unit. This causes attenuation of a radio frequency signal RFOUT_2 and reduces the gain, to achieve protection.

When the power amplifier module exits the average power protection operating mode, the third control signal ODP_EN is a low-level signal, the PMOS transistor M1 is turned on, the second resistor R2 is shorted, and the first bias voltage VBIAS is outputted after the outputted voltage VOUT of the VBIAS LDO circuit passes through the first resistor R1. In this case, the power amplification unit normally operates and maintains a normal gain.

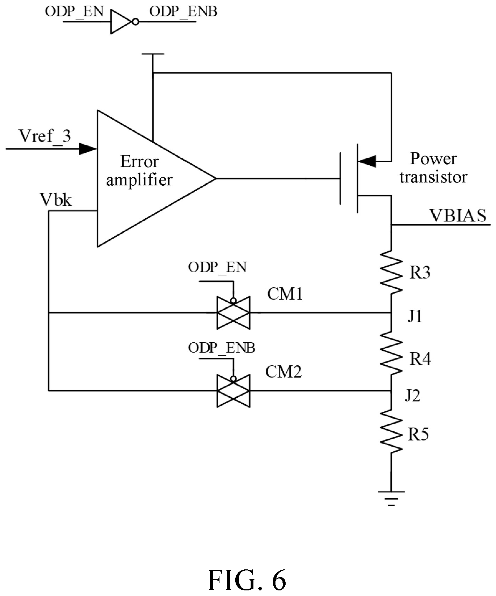

In a third embodiment of the present invention, as shown in FIG. 6, in an average power protection operating mode, a first bias voltage VBIAS outputted by a VBIAS LDO circuit is still controlled by a third control signal ODP_EN (shown in the dashed line ② in FIG. 1) to adjust a gain of a power amplifier, to achieve protection.

First, an inverted signal ODP_ENB of the third control signal is obtained through an inverter circuit.

The VBIAS LDO circuit includes an error amplifier, a power transistor, and a feedback resistor network. The feedback resistor network includes a third resistor R3, a fourth resistor R4, and a fifth resistor R5 that are connected in series between an output end and a ground potential end, a first transmission gate CM1, and a second transmission gate CM2. A connection point between the third resistor R3 and the fourth resistor R4 is a first node, and a connection point between the fourth resistor R4 and the fifth resistor R5 is a second node. The first node and the second node are connected to a feedback input end of the error amplifier respectively through the first transmission gate CM1 and the second transmission gate CM2, an enable control end of the first transmission gate CM1 is connected to a third control signal ODP_EN end, and an enable control end of the second transmission gate CM2 is connected to an inverted signal ODP_ENB end of the third control signal.

When a power amplifier module enters the average power protection operating mode, the third control signal ODP_EN is a high-level signal, and the inverted signal ODP_ENB of the third control signal is a low-level signal. Therefore, the first transmission gate CM1 is turned on, the second transmission gate CM2 is turned off, the first node in the feedback resistor network is connected to the feedback input end of the error amplifier, and the VBIAS LDO circuit outputs a first bias voltage VBIAS with a small piezoelectric value, that is, a biasing unit provides a small direct current operating point to a power amplification unit, to reduce an amplification capability (that is, to reduce a gain) of the power amplification unit. This causes attenuation of a radio frequency signal RFOUT_2 and reduces the gain, to achieve protection.

When the power amplifier module exits the average power protection operating mode, the third control signal ODP_EN is a low-level signal, and the inverted signal ODP_ENB of the third control signal is a high-level signal. Therefore, the first transmission gate CM1 is turned off, the second transmission gate CM2 is turned on, the second node in the feedback resistor network is connected to the feedback input end of the error amplifier, and the VBIAS LDO circuit outputs a first bias voltage VBIAS with a large piezoelectric value. In this case, the power amplification unit normally operates and maintains a normal gain.

In a fourth embodiment of the present invention, in an average power protection operating mode, a second bias voltage VLPM outputted by a VLPM LDO circuit is controlled by a third control signal ODP_EN (shown in a dashed line ③ in FIG. 1) to adjust a gain of a power amplifier, to achieve protection.

When a power amplifier module enters the average power protection operating mode, the third control signal ODP_EN is a high-level signal, so that the VLPM LDO circuit is turned on, and outputs a high-potential second bias voltage VLPM to a biasing unit of a radio frequency power amplifier, to change a node potential in the biasing unit, causing the biasing unit to output a low bias voltage, that is, the biasing unit provides a small direct current operating point to a power amplification unit, to reduce an amplification capability (that is, to reduce a gain) of the power amplification unit. This causes attenuation of a radio frequency signal RFOUT_2 and reduces the gain, to achieve protection.

When the power amplifier module exits the average power protection operating mode, the third control signal ODP_EN is a low-level signal, so that the VLPM LDO circuit is turned off, and outputs a low-potential second bias voltage VLPM to the biasing unit of the power amplifier, causing the biasing unit to output a normal bias voltage. In this case, the power amplification unit normally operates and maintains a normal gain.

In the foregoing four embodiments, the power amplifier module separately controls the radio frequency input switch unit, the VBIAS LDO circuit, and the VLPM LDO circuit through the third control signal ODP_EN, and a power of the power amplifier module entering the average power protection operating mode is adjusted by using four different technical solutions. The technical solutions provided in the foregoing four embodiments can be used individually or in combination.

Based on the foregoing power amplifier module for implementing average power protection, an embodiment of the present invention further provides an electronic device. The electronic device includes the power amplifier module for implementing average power protection as an important component of a communication assembly. The electronic device described herein refers to a computer device that may be used in a mobile environment, and supports a plurality of communication standards such as GSM, EDGE, CDMA, TD-SCDMA, WCDMA, TDD-LTE, FDD-LTE, and NR. The computer device includes a mobile phone, a notebook computer, a tablet computer, an in-vehicle computer, or the like. In addition, the technical solution provided in the present invention is also applicable to application scenarios of other radio frequency integrated circuits, for example, a communication base station and an intelligent connected vehicle.

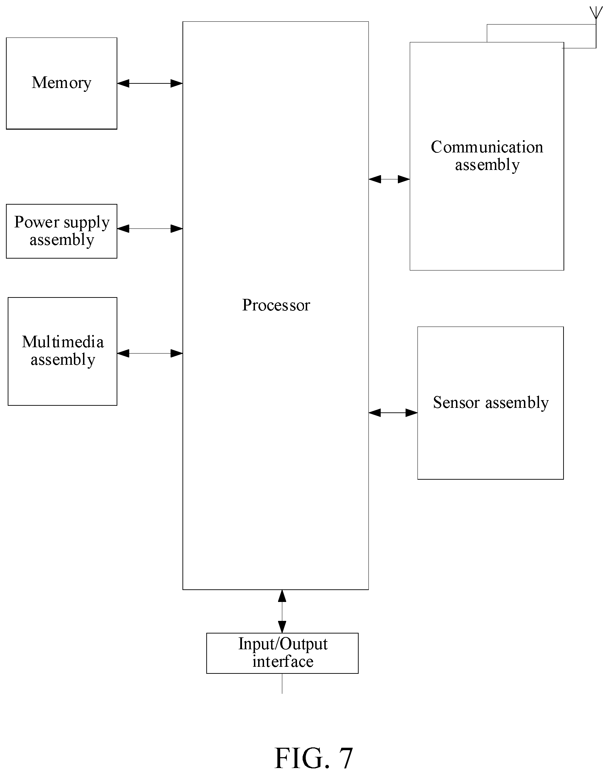

As shown in FIG. 7, the electronic device includes at least a processor, a memory, and the communication assembly, and may further include a sensor assembly, a power supply assembly, a multimedia assembly, and an input/output interface according to an actual requirement. The memory, the communication assembly, the sensor assembly, the power supply assembly, the multimedia assembly, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field-programmable gate array (FPGA), an application-specific integrated circuit (ASIC), a digital signal processing (DSP) chip, or the like. The other component such as the communication assembly, the sensor assembly, the power supply assembly, or the multimedia assembly may be implemented by using a general component. This is not described in detail herein.

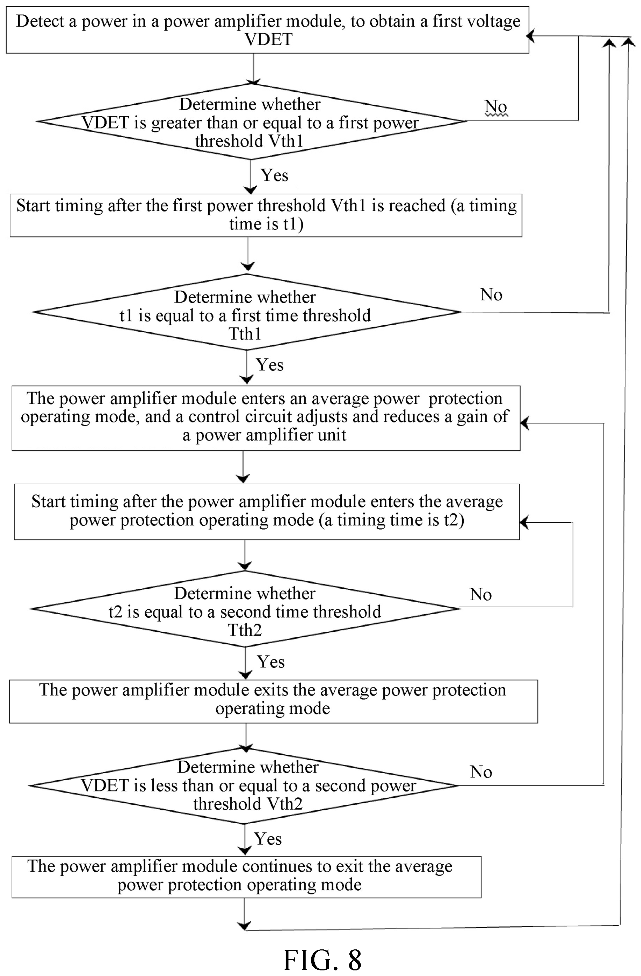

In addition, an embodiment of the present invention further provides a method for average power protection of a power amplifier module. An operating procedure of the method is shown in FIG. 8, and the following steps are included.

S1: Detect a power in the power amplifier module, to obtain a first voltage VDET.

An output power is detected in this embodiment. Alternatively, an input power may be detected in another embodiment, or an output power of a specific stage or branch of a power amplifier may be detected.

S2: Determine whether the first voltage VDET obtained through power detection is greater than or equal to a first power threshold Vth1; and perform a next step when the first voltage VDET is greater than or equal to the first power threshold Vth1; otherwise, return to step S1 and continue to detect the power.

The first power threshold Vth1 is set based on a power level that a filter integrated in the power amplifier module can withstand. A filter for different frequency bands can withstand different power levels.

S3: Start timing after the first voltage VDET is greater than or equal to the first power threshold Vth1, where the timing is a first timing time t1.

In this embodiment, the timing is performed by using a clock signal, and a frequency of the clock signal is correspondingly designed based on a length of a time threshold set as required.

S4: Determine whether the first timing time t1 reaches a first time threshold Tth1; and perform a next step when the first timing time reaches the first time threshold Tth1; otherwise, return to step S1.

In a process in which the timing is started after the first power threshold Vth1 is reached and the first timing time t1 does not reach the first time threshold Tth1, when the detected power is less than the first power threshold Vth1, timing is stopped, step S1 is returned to, and the power is continued to be detected.

The first time threshold Tth1 is determined and set jointly based on a duration for which the filter can withstand a high power and a duration needed to be covered for the filter in normal application.

S5: The power amplifier module enters an average power protection operating mode. A control circuit adjusts a gain of a power amplifier unit (mainly reduces the gain, but is not limited thereto), to protect the power amplifier module.

A first solution to reduce the gain of the power amplifier unit is that the control circuit controls a radio frequency input switch unit; and when the power amplifier module enters the average power protection operating mode, a radio frequency input signal is outputted after passing through a radio frequency path with an attenuation network, causing reduction of an output power and the gain of the power amplification unit, to achieve protection.

A second solution to reduce the gain of the power amplifier unit is that the control circuit controls a VBIAS LDO circuit; and when the power amplifier module enters the average power protection operating mode, the VBIAS LDO circuit outputs a reduced first bias voltage to a biasing unit of a power amplifier, and the gain of the power amplification unit is reduced, to achieve protection.

A third solution to reduce the gain of the power amplifier unit is that the control circuit controls a VLPM LDO circuit; and when the power amplifier module enters the average power protection operating mode, the VLPM LDO circuit outputs a high-potential second bias voltage to a biasing unit of a power amplifier, to change a node potential in the biasing unit, causing the biasing unit to output a reduced bias voltage, and the gain of the power amplification unit is reduced, to achieve protection.

S6: Start timing after the power amplifier module enters the average power protection operating mode, where the timing is a second timing time t2.

S7: Determine whether the second timing time t2 reaches a second time threshold Tth2; and perform a next step when the second timing time t2 reaches the second time threshold Tth2; otherwise, return to step S6 and continue the timing.

S8: The power amplifier module exits the average power protection operating mode.

S9: Determine whether the first voltage VDET obtained through power detection is less than or equal to a second power threshold Vth2; and perform a next step when the obtained first voltage VDET is less than or equal to the second power threshold Vth2; otherwise, return to step S5 and the power amplifier module continues to enter the average power protection operating mode.

The set first power threshold Vth1 is generally greater than the set second power threshold Vth2 by a specific margin, to ensure that there is a specific hysteresis width between entering and exiting the average power protection operating mode.

S10: The power amplifier module continues to exit the average power protection operating mode; and return to step S1.

After it is determined that the power amplifier module exits the average power protection operating mode, step S1 is returned to, the power is continued to be detected, and cyclical protection and real-time control in steps S1 to S10 are performed, to prevent the radio frequency power amplifier from continuously outputting an abnormally high power, to protect the power amplifier module.

In conclusion, compared with the related art, according to the power amplifier module for implementing average power protection provided in the present invention, a control signal is generated after real-time power detection and comparison with a set threshold, to control a relevant functional unit to adjust a gain of a power amplifier unit. This technical solution implements protection of the power amplifier module when an abnormally high power occurs. In this way, a radio frequency front end module can continue to evolve towards higher integration and miniaturization. Therefore, the power amplifier module for implementing average power protection according to the present invention has beneficial effects such as ingenious and proper structural design, low design costs, and high reliability.

It should be noted that, the foregoing plurality of embodiments are merely example descriptions. The technical solutions of the various embodiments may be combined, and all are within the protection scope of the present invention.

It should be noted that, terms "first" and "second" are used for descriptive purposes only and should not be construed as indicating or implying relative importance or implicitly indicating the number of technical features indicated. Therefore, features defining "first" and "second" may explicitly or implicitly comprise one or more such features. In the descriptions of the present invention, "a plurality of" means two or more, unless otherwise definitely and specifically limited.

The power amplifier module for implementing average power protection, the electronic device, and the method according to the present invention are described in detail above. For a person of ordinary skill in the art, any obvious modifications made to the present invention without departing from the essence of the present invention will constitute an infringement of patent rights of the present invention, and corresponding legal liabilities will be born.

## Claims

1. A power amplifier module for implementing average power protection, comprising:
a controller, configured to provide logic control and a bias voltage for a radio frequency power amplifier;
the radio frequency power amplifier, configured to amplify a power of a radio frequency signal and then output an amplified radio frequency signal to a filter; and
the filter for frequency bands, configured to filter the amplified radio frequency signal, to obtain a radio frequency signal of a required specific frequency band, wherein
when a detected power of the radio frequency power amplifier is greater than or equal to a first power threshold, and a time during which the detected power is greater than or equal to the first power threshold reaches a first time threshold, the power amplifier module enters an average power protection operating mode, and the controller adjusts a gain of a power amplifier unit.

2. The power amplifier module for implementing average power protection according to claim 1, wherein
when a time during which the power amplifier module enters the average power protection operating mode reaches a second time threshold, the power amplifier module exits the average power protection operating mode; then whether the detected power of the radio frequency power amplifier is less than or equal to a second power threshold is determined; and when the detected power is less than or equal to the second power threshold, the power amplifier module continues to exit the average power protection operating mode; otherwise, the power amplifier module continues to enter the average power protection operating mode.

3. The power amplifier module for implementing average power protection according to claim 1, wherein the controller comprises:
a power comparison unit, configured to perform comparison and determine whether the detected power reaches a set power threshold, and output a first control signal;
a bandgap reference, configured to provide a reference voltage for each relevant unit;
a frequency oscillator, configured to generate a clock signal and provide the clock signal to a timing unit;
the timing unit, configured to perform timing by using the clock signal, and output a second control signal after comparison with a set time threshold;
a VBIAS LDO circuit, configured to output a first bias voltage to a biasing unit of the radio frequency power amplifier;
a radio frequency input switch unit, configured to switch two radio frequency paths with different attenuation amounts; and
a logic control unit, configured to perform logic combination based on the first control signal and the second control signal, output a third control signal, and control a relevant functional unit to adjust the gain of the power amplifier unit, to achieve protection.

4. The power amplifier module for implementing average power protection according to claim 3, wherein the controller further comprises:
a VLPM LDO circuit, configured to output a second bias voltage, as a node potential, to the biasing unit of the radio frequency power amplifier, to change a bias voltage outputted by the biasing unit; and
an Efuse calibration unit, outputting a digital signal for performing calibration on the reference voltage of the bandgap reference, to ensure accuracy of the reference voltage.

5. The power amplifier module for implementing average power protection according to claim 3, wherein
the power comparison unit comprises a first voltage comparator and a second voltage comparator, wherein an input end of the first voltage comparator is separately connected to a first reference voltage end and an output end of a power detection unit, and an input end of the second voltage comparator is separately connected to a fifth reference voltage end and the output end of the power detection unit; and an output end of the first voltage comparator and an output end of the second voltage comparator each are connected to an output end of the power comparison unit, wherein
the first voltage comparator is configured to compare a first voltage outputted by the power detection unit with a first reference voltage; the second voltage comparator is configured to compare the first voltage outputted by the power detection unit with a fifth reference voltage in different time periods; and the first control signal is outputted based on a comparison result.

6. The power amplifier module for implementing average power protection according to claim 3, wherein
the power comparison unit comprises an analog-to-digital converter and a digital logic unit, wherein an input end of the analog-to-digital converter is connected to an output end of a power detection unit, an output end of the analog-to-digital converter is connected to a first input end of the digital logic unit, a second input end and a third input end of the digital logic unit each are connected to an Efuse calibration unit, and an output end of the digital logic unit is used as an output end of a power amplification unit, wherein
the analog-to-digital converter is configured to convert a first voltage outputted by the power detection unit into a fourth digital signal; the digital logic unit is configured to compare, in different time periods, the fourth digital signal separately with a second digital signal and a third digital signal that are provided by the Efuse calibration unit; and the first control signal is outputted based on a comparison result.

7. The power amplifier module for implementing average power protection according to claim 1, wherein the radio frequency power amplifier comprises:
a biasing unit, configured to provide a direct current operating point for a power amplification unit;
a power detection unit, configured to perform power detection on a radio frequency signal outputted by the power amplification unit, wherein a first voltage is outputted corresponding to a detection result; and
the power amplification unit, configured to amplify an inputted radio frequency signal and then output an amplified radio frequency signal.

8. The power amplifier module for implementing average power protection according to claim 3, wherein
the third control signal outputted by the logic control unit controls the radio frequency input switch unit, wherein
when the power amplifier module enters the average power protection operating mode, a radio frequency input signal is outputted after passing through a radio frequency path with an attenuation network, causing reduction of a gain of a power amplification unit; and
when the power amplifier module exits the average power protection operating mode, the radio frequency input signal is outputted after passing through a radio frequency path without an attenuation network, and in this case, the power amplification unit maintains a normal gain.

9. The power amplifier module for implementing average power protection according to claim 3 or 8, wherein
in the radio frequency input switch unit, the radio frequency path with an attenuation network and the radio frequency path without an attenuation network are connected in parallel with each other; the radio frequency path with an attenuation network comprises a first switch, the attenuation network, and a second switch, and the first switch, the attenuation network, and the second switch are sequentially connected in series, wherein a control end of the first switch and a control end of the second switch each are connected to a third control signal end; and the radio frequency path without an attenuation network comprises a third switch, and a control end of the third switch is connected to an inverted signal end of the third control signal.

10. The power amplifier module for implementing average power protection according to claim 3, wherein
the third control signal outputted by the logic control unit controls the VBIAS LDO circuit, wherein
when the power amplifier module enters the average power protection operating mode, the VBIAS LDO circuit outputs a reduced first bias voltage to the biasing unit of the power amplifier, and a gain of a power amplification unit is reduced; and
when the power amplifier module exits the average power protection operating mode, the VBIAS LDO circuit outputs a normal first bias voltage to the biasing unit of the power amplifier, and in this case, the power amplification unit maintains a normal gain.

11. The power amplifier module for implementing average power protection according to claim 3 or 10, wherein
the VBIAS LDO circuit comprises an error amplifier, a power transistor, a feedback resistor network, and a first resistor, a second resistor, and a PMOS transistor that are connected in series at an output end, wherein a source and a drain of the PMOS transistor are respectively connected to two ends of the second resistor, and a gate of the PMOS transistor is connected to a third control signal end.

12. The power amplifier module for implementing average power protection according to claim 3 or 10, wherein
the VBIAS LDO circuit comprises an error amplifier, a power transistor, and a feedback resistor network, wherein the feedback resistor network comprises a third resistor, a fourth resistor, and a fifth resistor that are connected in series between an output end and a ground potential end, a first transmission gate, and a second transmission gate; a connection point between the third resistor and the fourth resistor is a first node, and a connection point between the fourth resistor and the fifth resistor is a second node; and the first node and the second node are respectively connected to a feedback input end of the error amplifier correspondingly through the first transmission gate and the second transmission gate, an enable control end of the first transmission gate is connected to a third control signal end, and an enable control end of the second transmission gate is connected to an inverted signal end of the third control signal.

13. The power amplifier module for implementing average power protection according to claim 3 or 4, wherein
the third control signal outputted by the logic control unit controls the VLPM LDO circuit, wherein
when the power amplifier module enters the average power protection operating mode, the VLPM LDO circuit outputs a high-potential second bias voltage to the biasing unit of the power amplifier, to change the node potential in the biasing unit, causing the biasing unit to output a reduced bias voltage, and a gain of a power amplification unit is reduced; and
when the power amplifier module exits the average power protection operating mode, the VLPM LDO circuit outputs a low-potential second bias voltage to the biasing unit of the power amplifier, causing the biasing unit to output a normal bias voltage, and the power amplifier maintains a normal gain.

14. An electronic device, comprising the power amplifier module for implementing average power protection according to any one of claims 1 to 13.

15. A method for average power protection of a power amplifier module, comprising the following steps:
(1) detecting a power in a power amplifier module;
(2) determining whether a detected power is greater than or equal to a first power threshold; and performing a next step when the detected power is greater than or equal to the first power threshold; otherwise, returning to step (1) and continuing to detect the power;
(3) starting timing after the detected power is greater than or equal to the first power threshold, wherein the timing is a first timing time;
(4) determining whether the first timing time reaches a first time threshold; and performing a next step when the first timing time reaches the first time threshold; otherwise, returning to step (1);
(5) entering, by the power amplifier module, an average power protection operating mode; and adjusting, by a control circuit, a gain of a power amplifier unit, to protect the power amplifier module;
(6) starting timing after the power amplifier module enters the average power protection operating mode, wherein the timing is a second timing time;
(7) determining whether the second timing time reaches a second time threshold; and performing a next step when the second timing time reaches the second time threshold; otherwise, returning to step (6) and continuing the timing;
(8) exiting, by the power amplifier module, the average power protection operating mode;
(9) determining whether the detected power is less than or equal to a second power threshold; and performing a next step when the detected power is less than or equal to the second power threshold; otherwise, returning to step (5) and continuing to enter, by the power amplifier module, the average power protection operating mode; and
(10) continuing to exit, by the power amplifier module, the average power protection operating mode; and returning to step (1).

16. The method for average power protection of the power amplifier module according to claim 15, wherein in step (5):
the control circuit controls a radio frequency input switch unit; and when the power amplifier module enters the average power protection operating mode, a radio frequency input signal is outputted after passing through a radio frequency path with an attenuation network, causing reduction of a gain of a power amplification unit.

17. The method for average power protection of the power amplifier module according to claim 15, wherein in step (5):
the control circuit controls a VBIAS LDO circuit; and when the power amplifier module enters the average power protection operating mode, the VBIAS LDO circuit outputs a reduced first bias voltage to a biasing unit of a power amplifier, and a gain of a power amplification unit is reduced.

18. The method for average power protection of the power amplifier module according to claim 15, wherein in step (5):
the control circuit controls a VLPM LDO circuit; and when the power amplifier module enters the average power protection operating mode, the VLPM LDO circuit outputs a high-potential second bias voltage to a biasing unit of a power amplifier, to change a node potential in the biasing unit, causing the biasing unit to output a reduced bias voltage, and a gain of a power amplification unit is reduced.
